# EUROPEAN PATENT APPLICATION

(11) **EP 2 019 156 A1**
(43) Date of publication of application: **28.01.2009**
(21) Application number: 07014811.9
(22) Date of filing: 27.07.2007
(51) Int. Cl.: C30B 35/00, C30B 29/54, C23C 14/24

(54) **Shaped crucible and evaporation apparatus having same**

(71) Applicant: Applied Materials, Inc., Santa Clara, CA 95054 (US)
(72) Inventor: Englert, Ulrich, 63869 Heigenbrücken (DE)
(74) Representative: Zimmermann, Gerd Heinrich

(57) **Abstract**

A crucible for an evaporation apparatus with the crucible having a length, a width, and a thickness is provided. The crucible comprises an evaporation side for receiving and evaporating material to be evaporated and a back side located on the back of the evaporation side with the evaporation side and the back side having a non-flat surface. Further, an evaporation apparatus having at least one crucible is provided.

## Description

### FIELD OF THE INVENTION

The invention generally relates to thin-film forming apparatuses and crucibles used in an evaporation apparatus for thin film forming. Particularly, it relates to a crucible and an evaporation apparatus for evaporation of alloys or metals, and an evaporation method. More specifically, it relates to a crucible for an evaporation apparatus and an evaporation apparatus for use in the production of organic light emitting diodes.

### BACKGROUND OF THE INVENTION

For thin-film coating of a material on a substrate, an evaporation apparatus can be used. For example, coatings with metal films, which e.g. provide a capacitor of a large panel display or a protective layer on a flexible substrate or web can be applied with evaporation apparatuses.

In particular, organic evaporation apparatuses are an essential tool for certain production types of organic light-emitting diodes (OLEDs). OLEDs are a special type of light-emitting diodes in which the emissive layer comprises a thin-film of certain organic compounds. Such systems can be used in television screens, computer displays, portable system screens, and so on. OLEDs can also be used for general space illumination. The range of colours, brightness, and viewing angle possible with OLED displays are greater than that of traditional LCD displays because OLED pixels directly emit light and do not require a back light. Therefore, the energy consumption of OLED displays is considerably less than that of traditional LCD displays. Further, the fact that OLEDs can be printed onto flexible substrates opens the door to new applications such as roll-up displays or even displays embedded in clothing.

In general, the stack of emissive layer and conductive layer of an OLED is sandwiched by electrodes. The functionality of an OLED depends, inter alia, on the coating thickness of the electrodes. In the production of OLEDs it is therefore important that the coating rate at which the coating with electrode material is effected lies within a predetermined tolerance range. It is generally desirable that the coating thickness is as uniform as possible. Moreover, when coating the substrate with material such as a metal, the layers already deposited on the substrate, in particular layers of organic materials shall not be damaged by side effects of the evaporation process such as plasma radiation. Specifically the organic materials are more sensitive to damages than the non-organic materials used in conventional evaporation processes.

### SUMMARY OF THE INVENTION

In light of the above, the present invention provides a crucible according to claim 1 and an evaporation apparatus according to claim 32.

According to an aspect of the present invention, a crucible is provided for an evaporation apparatus, the crucible having a length, a width, and a thickness, wherein the crucible comprises an evaporation side for receiving and evaporating material to be evaporated and a back side located on the back of the evaporation side with each of the evaporation side and the back side having a non-flat surface.

According to another aspect of the present invention, an evaporation apparatus is provided that has one or more crucibles according to the invention.

According to another aspect, the present invention provides a crucible for an evaporation apparatus, the crucible being made of a first material and having an evaporation side for receiving and evaporating material to be evaporated, wherein the crucible further comprises a member made of a second material. Typically, the electrical conductivity of the second material is smaller than the electrical conductivity of the first material. More typically, the second material is an insulator. Typically, the member is located on the evaporation side of the crucible. Typically, the member is located in the middle of the crucible. Typically, the member is in a form-fit contact with the crucible.

Further advantages, features, aspects and details that can be combined with the above embodiments are evident from the dependent claims, the description and the drawings.

Embodiments are also directed to apparatuses for carrying out the disclosed methods and including apparatus parts for performing each described method steps. These method steps may be performed by way of hardware components, a computer programmed by appropriate software, by any combination of the two, or in any other manner. Furthermore, embodiments are also directed to methods by which the described apparatus operates or by which the described apparatus is manufactured. It includes method steps for carrying out functions of the apparatus or manufacturing parts of the apparatus.

### BRIEF DESCRIPTION OF THE DRAWINGS

Some of the above indicated and other more detailed aspects of the invention will be described in the following description and partially illustrated with reference to the figures. Therein:

Figures 1A, 1B, 1C show a first crucible known in the state of the art;

Figures 2A, 2B, 2C show a second embodiment of a crucible known in the art;

Figures 3 to 11 show the cross-sections of various embodiments of the crucible according to the present invention along its width;

Figure 12 shows an embodiment of a crucible according to the present invention in a schematic view;

Figures 13A, 13B, 13C, 14A, 14B and 14C show cross-sections of embodiments of the crucible according to the present invention along its length;

Figures 15A and 15B show an embodiment of a crucible according to the present invention in a schematic view;

Figures 16A and 16B show another embodiment of a crucible according to the present invention in schematic view;

Figure 16C shows a cross-sectional view of the embodiment of Figures 16A and 16B.

Figure 17A is a cross-sectional view of a crucible according to the present invention;

Figures 17B and 17C are cross-sectional views of the crucible shown in Fig. 17A;

Figure 17D is an equivalent circuit diagram with respect to the crucible of Figures 17A-17C for better understanding the present invention;

Figure 17E is a cross-sectional view of a crucible according to the present invention;

Figures 17F and 17G are cross-sectional views of the crucible shown in Fig. 17E;

Figure 17H is an equivalent circuit diagram with respect to the crucible of Figures 17E-17G for better understanding the present invention;

Figures 18A, 18B, 19 and 20 show several embodiments of an evaporation apparatus according to the present invention;

Figure 18C shows an embodiment of an aperture for use in the evaporation apparatus according to the present invention;

Figures 21A and 21B show embodiments of an evaporation apparatus according to the present invention having several crucibles.

Figure 22 shows the equivalent schematic diagram for an embodiment of a crucible being asymmetric with respect to its length direction.

Figure 23 shows a first embodiment of a crucible according to the present invention having a member.

Figure 24 shows a second embodiment of a crucible according to the present invention having a member and a cavity disposed below the member.

### DETAILED DESCRIPTION OF THE DRAWINGS

Without limiting the scope of the present invention, a substrate is typically referred to as a glass substrate as often used for display technology, e.g., displays. Embodiments of the present invention can be applied to thin-film vapor deposition on other substrates and for other technologies, e.g., for flexible substrates or webs. In particular, embodiments of the present invention can be used in OLED production.

Within the following description of the drawings, the same reference numbers refer to the same components. Generally, only the differences with respect to the individual embodiments are described.

Typically, the material to be evaporated is evaporated thermally in the embodiments of the present invention.

In general, and particularly for large panel displays, a substrate, which e.g. can be provided as a large and relatively thin glass plate, is typically vertically positioned in a coating process and coated with a vertical evaporation apparatus. The term "relatively thin" in this context refers to typical glass thicknesses of between 0.4 mm and 1.1 mm such as 0.7 mm. The term "vertical evaporation apparatus" shall be defmed as an evaporation apparatus arranged and adapted for coating a vertically oriented substrate. Further, the term "substrate" shall also include films and the like. The substrates that are processed according to the present invention may already be coated with organic material and/or may still be to be coated with organic material.

Vertical evaporation as taught by the present invention allows for the continuous in-line production of coated substrates, such as OLEDs. More particularly, vertical evaporation allows the coating of large substrates. Typical substrate sizes that can be handled by the evaporation apparatus according to the present invention are, for instance, up to 110 cm. In general, the crucible of the present invention and the evaporation apparatus of the present invention are particularly applicable in the OLED production.

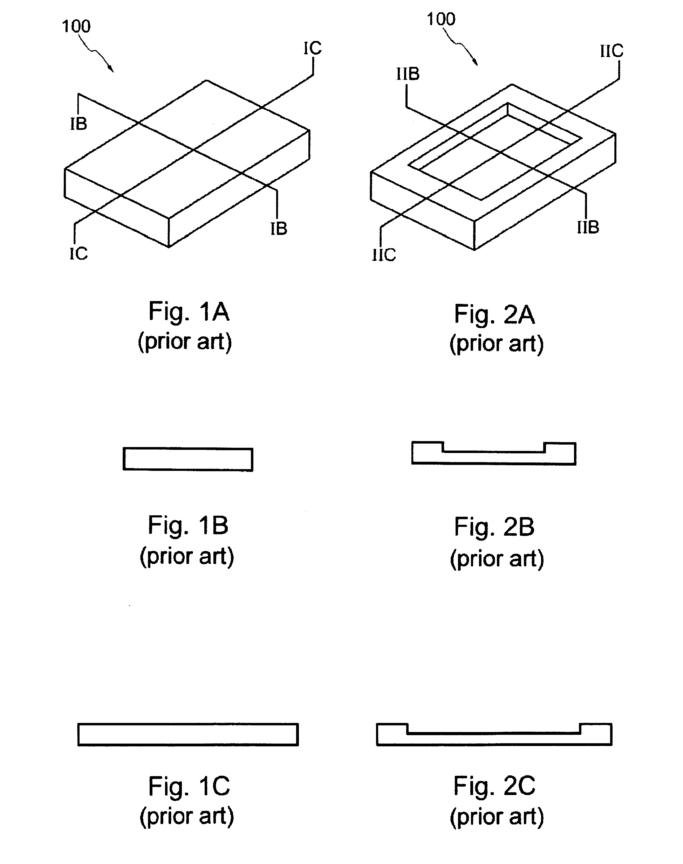

In Fig. 1A a crucible 100 as known in the art is shown. In Fig. 1B a cross-section along the width of the crucible 100 is shown whereas in Fig. 1C the cross-section along the length of the crucible according to Fig. 1A is shown. As can be seen in these figures, the shape of the crucible is rectangular; the surface of the crucible is planar.

Fig. 2A shows another crucible known in the art. In Fig. 2B the cross-section of the crucible according to Fig. 2A along its width is shown whereas Fig. 2C shows the cross-section of the crucible along its length. As can be seen in Figs. 2A to 2C, the crucible has a recess on the upper side. If not stated otherwise, the upper side of crucibles depicted in the figures of the present application refers to the evaporation side. The evaporation side is the side of the crucible that receives the material to be evaporated when the crucible is in operation. The evaporation takes place on the evaporation side. The term "evaporation surface" may be used synonymously for "evaporation side" within the present application.

The present invention provides a crucible that is non-flat on both the evaporation side and the back side. The back side shall be defmed as the side on the back of the evaporation side of the crucible. The term "back surface" may be used synonymously for the term "back side" within the present application.

According to the present invention, the evaporation side and the back side are structured. That is, the evaporation side and the back side are provided with at least one elevation and/or recess. According to the understanding of the present application, the evaporation side is provided with an elevation or recess if not every point of the evaporation surface is in contact with a flat underground when the crucible is laid down on the underground with the evaporation side facing the underground. The same is true for the back side. It is of course understood that "every point" shall not be taken literally. A planar crucible, for instance, may in practice comprise several points on the surface that are not in direct contact with a flat underground surface if the crucible is laid down on the underground surface. This occurs due to production tolerances and the like.

However, in the present application an elevation or recess is understood as an elevation or recess that has been intentionally made on or in a crucible. In typical embodiments of the present invention, an elevation has a height of at least 1 mm above the surrounding surface. A typical recess as understood within the present application has a depth of at least 1 mm below the surface surrounding of the recess. In other embodiments, the height and depth of the elevation and recess may be more accurately defined in relation to the thickness of the crucible. In typical embodiments of the present invention, the elevation is at least 5% or more typically more than 10% higher than the surrounding surface in relation to the total average thickness of the crucible. In addition or alternatively, the recess may have a depth of at least 5% or more typically more than 10% below the surrounding surface in relation to the total average thickness of the crucible.

The term "thickness" may synonymously used with the term "thickness distribution". The total average thickness of the crucible is understood as the average of the thickness values of the complete crucible. In some embodiments, the edge region of the crucible shall not be included in the calculation of the total average thickness. In general, within the present application, the "edge region" shall be understood as the region close to the edge in the respective direction. More typically, the edge region shall be understood as extending about 10% of the total surface of the respective side. In many embodiments of the present invention, the edge region is planar on the evaporation side and/or the back side. Further, in many embodiments of the present invention, the edge region of the crucible has the form of a rectangular shaped bar. In typical embodiments, the thickness of the crucible at the edge is identical in the direction of the length and/or the width. Typically, the edge region is integrally formed with the rest of the crucible.

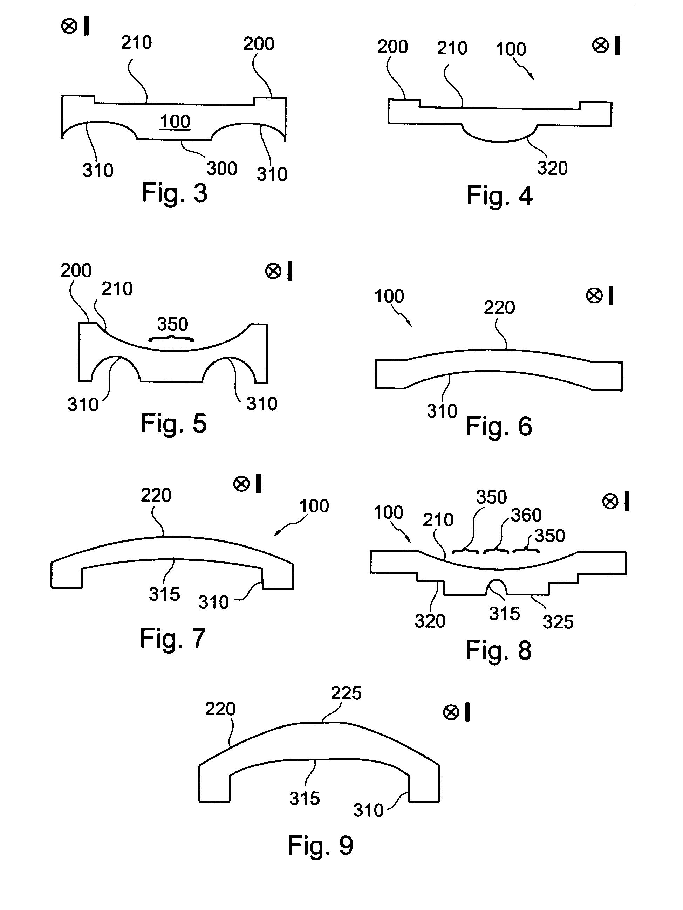

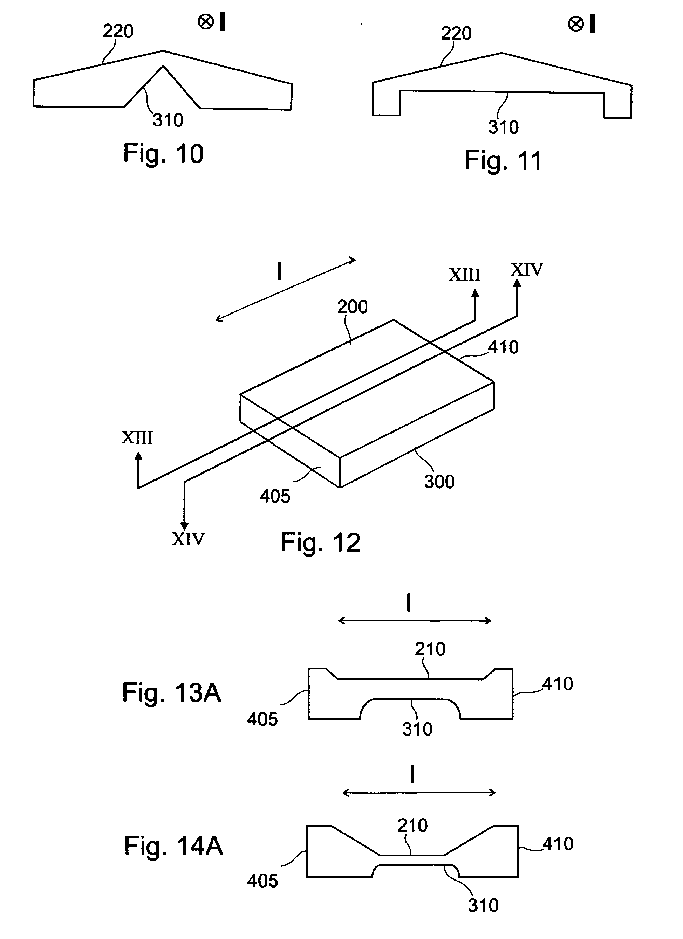

In the following, the cross-sections of several embodiments of the crucible according to the present invention are exemplarily described. In Figs. 3 to 11, the cross-sections along the width of the crucible are depicted. In Figs. 13A to 14C, the cross-sections along the crucible's length are depicted. It shall be emphasized that the concrete shapes of the evaporation side and the back side of the exemplary crucibles can, in theory, be arbitrarily combined with each other. That is, the shape of the evaporation side is not strictly correlated to the shape of the back side in all the embodiments shown and discussed in the following.

In the following Figures 3-11, the current I flows perpendicular to the drawing plane when the crucible is in operation. In other word, the current flows into the drawing plane or out of the drawing plane. This is indicated by the dotted crossed circle that is labelled with "I" in the figures.

Starting with Fig. 3, the cross-section along the width of a crucible 100 is shown. The crucible has the evaporation side 200 and the back side 300. On the evaporation side, a recess 210 is depicted. The recess itself has a rectangular shape in the embodiment shown but could also be, for instance, of a concave shape. Further, on the back side of the crucible there aretwo recesses 310. The recesses have a concave shape.

The term "convex" within the present application shall be understood as an elevation on the crucible with a substantially continuous slope. For instance, in three dimensions, the slope may be of spherical, pyramidal, or cylindrical shape. For instance, in two dimensions, the slope may be of a circular shape, an ellipsoid shape, a triangular shape, a trapezoid shape, or a flattened circular or ellipsoid shape.

Analogously, the term "concave" within the present application shall be understood as a recess with a substantially continuous slope. For instance, in three dimensions, the slope may be of spherical, pyramidal, or cylindrical shape. For instance, in two dimensions, the slope may be of a circular shape, an ellipsoid shape, a triangular shape, a trapezoid shape, or a flattened circular or ellipsoid shape.

A slope may be positive or negative. In the case of a convex or concave shape, it is typically positive in one part of the shape, and negative in another part of the shape. A concave or convex shape may also comprise a substantially flat part, i.e. a part with a surface gradient equal or close to zero.

In typical embodiments of the present invention, the crucible has at least one convex elevation that extends between 2 mm and 2 cm along the width and/or length of the evaporation side and/or the back side, more typically between 5 mm and 1.5 cm. It is also typical that the at least one concave elevation extends between 10% and 50% of the width and/or length of the evaporation side and/or back side of the crucible.

It is typical that the crucible has a convex shape on the evaporation side of the crucible in regions being used for melting the material to be evaporated and evaporating the material. This results in an additional widening of the evaporation characteristics in these regions. With respect to the design of the temperature distribution on the crucible, it has to be taken into account that a larger region results in a larger radiation and thus cooling of the region. The same is true for the convexity of the evaporation side. The more convex the shape of the evaporation side is the higher the radiation and cooling.

In other typical embodiments of the present invention, the crucible has at least one concave recess that extends between 2 mm and 2 cm along the width and/or length of the evaporation side and/or the back side, more typically between 5 mm and 1.5 cm. It is also typical that the at least one concave elevation extends between 10% and 50% of the width and/or length of the evaporation side and/or back side of the crucible.

In many embodiments of the present invention, the crucible is heated by a current. In order to do so, the crucible is provided with contact areas. The contact areas are connectable to the electrodes of a current supply. The crucible is heated due to its electrical resistivity when a voltage is applied to the electrodes of the crucible.

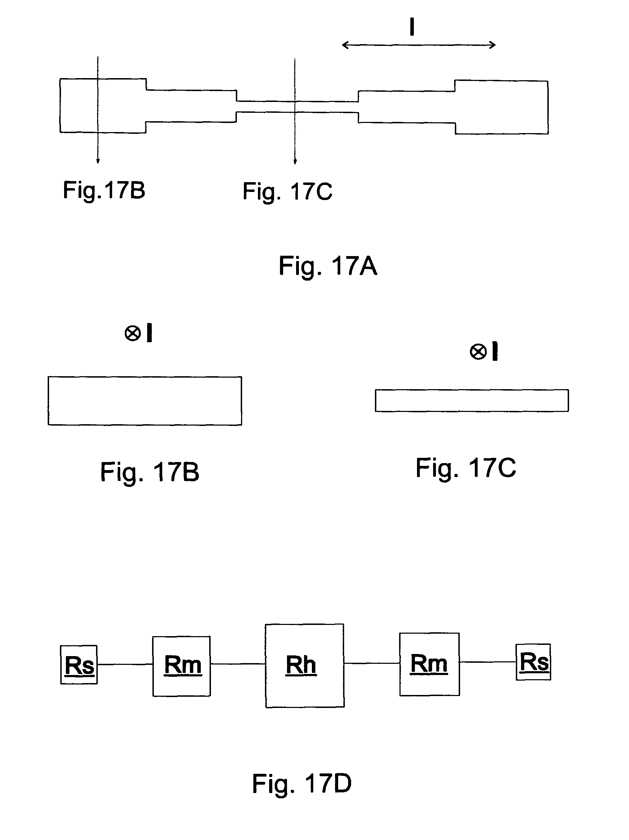

Experiments have shown that the crucible is not heated homogeneously. Instead, there are regions of the crucible that get hotter whereas other regions of the crucible remain colder.. This will be explained in detail with respect to Figures 17A to 17H. Hence, shaping the crucible allows for the design of the temperature distribution of the crucible.

In general, the crucible according to the present invention has a varying thickness with respect to the length and/or width direction. The varying thickness results in varying temperatures on the evaporation side of the crucible when it is connected to a voltage.

A crucible with the thickness distribution as shown in Fig. 3 provides for different temperature on the evaporation surface 200. In more detail, in the embodiment shown, the temperature is smaller in the regions around the middle of the crucible. The highest temperature is in the middle of the crucible, that is, in the region with the largest thickness of the crucible. In general, and not limited to the embodiment shown in Fig. 3, the recesses on the back side of the crucible help to design the temperature distribution and temperature gradient on the evaporation side when the crucible is in operation.

In Fig. 4, the crucible shown has a middle region with the largest thickness and thus the largest resulting temperature in operation of the crucible. The crucible is provided with an elevation 320 in the middle region on the back side of the crucible. The elevation has a convex shape. Hence, the current through the middle is the largest resulting in the highest temperature of the crucible.

The crucible shown in Fig. 5 is provided with a recess 210 whose shape is concave. On the back side, two recesses 310 are provided.

The cross-sectional shape of a recess on the evaporation side and/or back side can generally, and not limited to the present embodiment, be semi-circular. In other embodiments, the cross-section shape of a recess in the evaporation side and/or back side may be rectangular in the outer region of the recess and semi-circular in the inner region of the recess.

The shape of the embodiment shown in Fig. 5 has two regions disposed around the middle of the crucible where the middle has the largest thickness. The middle region 350 between these regions has the highest temperature. Hence, the embodiment according to Fig. 5 shows a crucible adapted for providing one hottest regions, i.e. one so-called "hot spot".

Generally, the region on the evaporation side with the highest temperature shall be called "hot spot". Typically, the material is evaporated at, or close to the hot spot. The hot spot can be defined as that region on the evaporation side of the crucible where the thickness of the crucible is the largest along the width direction of the crucible. Typically, the hot spot of the present invention has a surface area of between 200 to 16,000 mm² (e.g. 200 mm times 80 mm), more typically between 500 and 1,500 mm². The surface size is determined by the evaporation rate desired.

According to typical embodiments of the present invention, the crucibles provide for two hot spots. This will exemplarily be explained in view of Fig. 8. According a two-hot spots embodiment, a region with a smaller temperature is surrounded by two hot spots. Typically, the material to be evaporated is fed to the region that is surrounded by the two hot spots. This region shall be called melting zone. In Fig. 8, this zone is denoted with the reference number 360. The material fed to this zone is typically fed as solid material and is melted within this zone. The regions around the melting zone, i.e. the hot spots, shall be called evaporation zones. Typically, the material melted in the melting zone disperses towards the hotter regions, i.e. the evaporation zones. Due to the higher temperature, the material is evaporated in these regions.

In the embodiment shown in Fig. 6, the crucible 100 has a convex elevation 220 on the evaporation side and a concave recess 310 on the back side. As shown, the radius assignable to the elevation 220 is larger than the radius assignable to the recess 310. The assignable radius shall be understood as the radius of an imaginary circle partly coincident with the cross-section of the elevation or the recess. This results in a thickness distribution with the smallest thickness in the very middle of the crucible and an increasing thickness starting from there towards the edge of the crucible. The temperature is diminishing towards the middle of the crucible when the crucible is in operation. Typical radius values are between 1 mm and 8 mm, for instance between 3 mm and 5 mm.

In typical embodiments of the present invention, the recess and/or the elevation on the evaporation side and/or back side does not extend to the edge of the crucible.

The crucible shown in Fig. 7 has a convex evaporation side. This embodiment differs from the embodiments shown in that the complete evaporation side is convex. Further, the embodiment has the recess 310, 315 wherein the recess 310 is a rectangular recess with the additional recess 315 which is of a concave shape and flattened in the middle of the recess 315. Along with the convex elevation on the evaporation side, this shaping of the crucible results in the middle region having the largest thickness and therefore the highest temperature when the crucible is in operation. In other words, Fig. 7 shows an embodiment that provides for one hot spot only, and that hot spot is arranged centrally on the crucible along the width direction.

In general, the elevation and/or recess may cover only a part of the evaporation and/or back side. Typically, at least 70% of the evaporation side and/or back side are covered, more typically at least 50%. This percentage is to be understood as the overall surface of the elevation or recess in relation to the overall surface of the respective side, i.e. the evaporation side or back side. In other embodiments, the percentage is calculated as the extension of the elevation or recess along the length or width direction of the crucible in relation to the overall length or width of the crucible with respect to the respective side, i.e. the evaporation side or back side.

The crucible 100 of Fig. 8 has a concave recess 210 on the evaporation side. On the back side there is a two-stage elevation 320, 325. In addition, there is the recess 310 positioned in the middle of the crucible along the crucible's width. In operation, the crucible shown in Fig. 8 has two hot spots, i.e. the evaporation zones 350. In these zones, the thickness of the crucible is the largest. In the melting zone 360 between the hot spots 350, the thickness is smaller due to the concave shape of the elevation side and the recess on the back side. Hence, in operation, the temperature is smaller in comparison to the hot spots. As already explained previously, the melting zone is typically fed with the material to be evaporated whereas the melted material typically evaporates in the evaporation zone.

In general, it is typical that an elevation or a recess according to the present invention may be multi-staged with 2 to 10 stages, even more typically with between 2 and 5 stages. Typically, each step has a height of between 0.5 mm and 5 mm. The relation between the steps is typically such that the closer the step is located to the middle of the crucible, the smaller is the step.

In general, an elevation according to the present invention can be continuous or discontinuous. A discontinuous elevation has typically the form of a step. If an elevation is multi-staged, it has the form of several steps. On the contrary, a continuous elevation is not provided with those sudden changes of the crucible thickness. The gradient can be calculated on all points of the respective continuous part of the surface. Typical embodiments of the crucible according to the present invention have a region of typically between 5% and 20% of the overall surface of the evaporation side wherein the thickness of the crucible is continuously amended such as reduced.

Similarly, a discontinuous recess is understood as having the form of one or more steps. A continuous recess is understood as having a surface whose gradient does not become arbitrarily large or small. According to the present invention, the evaporation side and/or the back side may be provided with one or more continuous and/or discontinuous recesses and/or elevations.

Typically, the back side is provided with a recess and/or an elevation. In typical embodiments, the recess and/or elevation has a continuous part in the middle of the crucible along its width.

In the embodiment shown in Fig. 9, the recess on the back side is conceptually similar to the recess on the back side of the embodiment shown in Fig. 7. The elevation 220 on the evaporation side starts at the edge of the crucible. However, the convex shape of the elevation is flattened in the region 225 close to the middle of the crucible. As discussed before, all of the exemplary shapes shown in these embodiments of Figs. 3 to 11 can, in theory, be arbitrarily combined. For instance, the flattened region 225 shown in Fig. 9 could be applied also in all the other embodiments discussed, both on the evaporation side and back side.

Fig. 10 shows another embodiment of the crucible according to the present invention with an elevation 220 that increases steadily towards the middle of the crucible on the evaporation side and a recess 310 that extends into the crucible in a steeper way than the elevation 220 extends out of the crucible. As a result, when in operation, there are two hot spots positioned around the very middle of the crucible. In the middle region, the thickness is, due to the recess 310, reduced. Therefore, the temperature in the middle is smaller than the temperature on the hot spots.

Typically, steadily increasing elevations and/or recesses according to the present invention have a lead angle of between 2° and 20°, more typically between 5° and 15°.

Fig. 11 shows an embodiment of a crucible according to the present invention whose evaporation side is shaped similarly to the embodiment of Fig. 10. However, the recess 310 on the back side is not provided with a slope but is of a rectangular cross-sectional shape. Hence, this embodiment provides for single hot spot located in the very middle of the crucible along its width.

So far, the cross-sections of several embodiments of the crucible according to the present invention along its width have been discussed. In the following, some exemplary shapes along the length of the crucible shall be described.

The crucible extends along three dimensions. In general, the direction in which the crucible has the largest extension defines the direction of the length of the crucible. Analogously, the direction in which the crucible's extension is the smallest, defines the direction of the thickness of the crucible. The direction of the width of the crucible is defined as being perpendicular to the thickness direction and length direction. Typically, the crucible is adapted for having the current I flowing along the length of the crucible when the crucible is in operation. This is indicated by the labelled arrows in Figures 12-16B, 17A, and 17E.

In an evaporation apparatus according to the present invention, the crucible is typically mounted at the front and back side with respect to the length of the crucible. Typically, the connection to a voltage supply is effected at these sides, too. For instance, the crucible shown in Fig. 12 is both mounted and connected to the voltage at the contact areas 405 and 410.

The crucible shown in Fig. 12 is a very schematic view of a crucible according to the present invention. No recess or elevation can be recognized in this figure. This is due to the fact that this crucible shown stands for all possible embodiments of the crucible according to the present invention. The purpose of Fig. 12 is mainly to show along which positions the cross-sections of Fig. 13A to 14C are taken. Further, as illustrated in Fig. 12, the crucible according to the present invention is typically rectangular with the longer side of the rectangle typically defining the length of the crucible and the short side of the rectangle typically defining the width of the crucible.

All cross-sections of Fig. 13A to 14C are taken along the length of the crucible. As shown in Fig. 12, the cross-sections depicted in Figs. 14A to 14C are cross-sections through the middle of the crucible. The cross-sections depicted in Figs. 13A to 13C are taken from close to the middle of the crucible. The crucibles' shapes shown are assumed to be symmetric with respect toa plane through the middle of the crucible along its length.

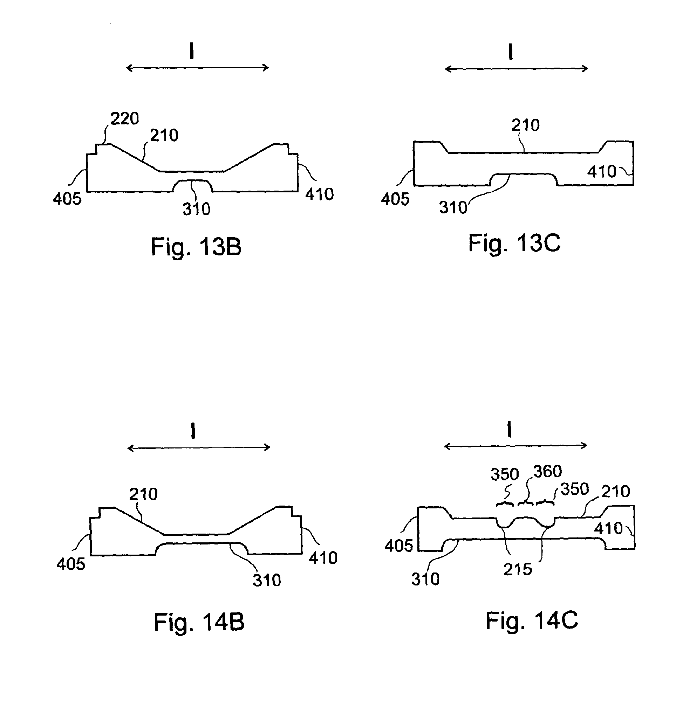

In the following, three different embodiments of the crucible are discussed. For each of the embodiments two different cross-sections are shown. The cross-sections shown in Fig. 13A and 14A refer to a first embodiment of the crucible according to the present invention; the cross-sections shown in Fig. 13B and 14B refer to a second embodiment of the crucible according to the present invention; and the cross-sections shown in Figs. 13C and 14C refer to a third embodiment of a crucible according to the present invention.

The crucible of the first embodiment is provided with the recess 210 on the evaporation side and the recess 310 on the back side as shown in Fig. 13A. The recess 210 is even deeper along the cross-section line XIV, i.e. in the middle with respect to the width of the crucible. This can be seen in Fig. 14A. Hence, when in operation, the temperature in the length direction of the crucible is the smallest in the edge regions. The temperature in the middle region with respect to the length is the highest. In this region, however, the temperature in the middle with respect to the width is smaller than in the regions around the middle with respect to the width. That is, the embodiment shown provides for two hot spots.

The second embodiment is shown in Figs. 13B and 14B. The evaporation side comprises an elevation 220 and a recess 210. The relation of the elevation 220 and the recess 210 is such that the bottom region of the recess 210 is lower than the edge region of the crucible. Closer to the middle of the crucible, as shown in Fig. 13B, the crucible comprises a recess 310 on the back side. The recess is arranged co-symmetrically to the recess 210 on the evaporation side. The recess is increasing towards the middle of the crucible along its width as can be seen in Fig. 14B. There, the recess 310 has a bottom surface whose cross-section shown is even larger than the cross-section of the bottom surface of the recess 210 on the evaporation side.

The third embodiment is shown in Figs. 13C and 14C. As shown in Fig. 13C, the cross-section is provided with a recess 210 on the evaporation side and a recess 310 on the back side. The cross-section along the line XIV in Fig. 12 is shown in Fig. 14C. The recess 310 in the middle of the crucible with respect to its width is enlarged in comparison to the recess closer to the edge as shown in Fig. 13C. On the evaporation side, there are two further recesses 215 in addition to the overall recess 210. As it is possible in all embodiments of the present invention, the edges of the recesses are rounded.

The embodiment of the crucible shown in Figs. 13C and 14C is provided with two hot spots on the evaporation side, i.e. the two recesses 215. In typical embodiments, the evaporation material is fed to the area between the two recesses, i.e. the melting zone. The material to be evaporated is typically melted on the melting zone 360 and flows to the hot spots 350 where it is evaporated.

In general, embodiments of a crucible according to the present invention may comprise a multitude of recesses and/or elevations on the evaporation side and/or back side. Further, and not limited to the embodiment discussed, the shape of a recess and/or elevation may be semi-circular, partly circular, rectangular, quadratic, ellipsoid, trapezoid, triangular, multiangular and the like.

In general, when designing a crucible, several aspects have to be considered. Firstly, as explained thoroughly in the present specification, the thickness distribution of the crucible has a large influence on the temperature when the crucible is in operation. Secondly, the the area on the crucible, to which the material is fed to, is cooled by the energy the evaporation of the material consumes. Therefore, this area may have a smaller temperature than spots close to this area that may have the identical thickness.

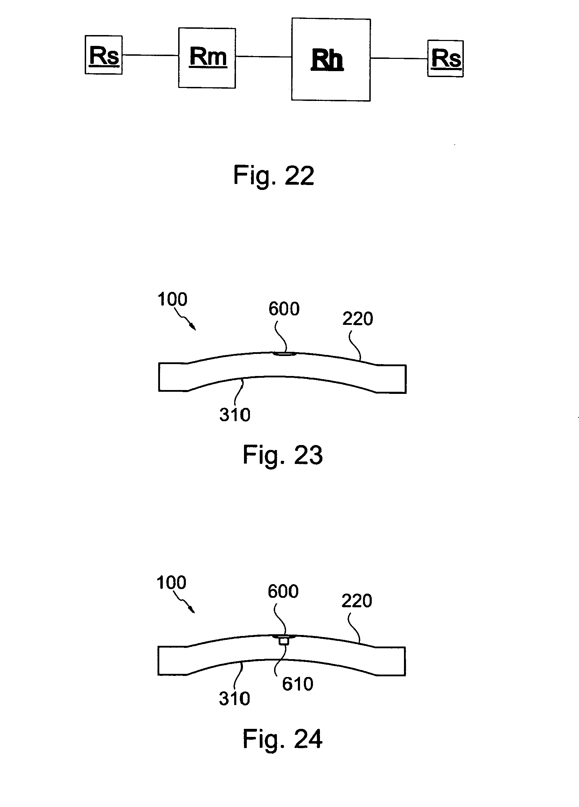

Further, heat conduction may have an influence. For instance, a position on the crucible where a high amount of current heats this position may be cooled down by regions close to this position having only a very small temperature. The effect of heat conduction is exploited in the embodiments of the present invention that provide for a low-conductive or non-conductive part embedded in the crucible as will be explained in more detail with respect to Figures 22 and 23. As a further effect, the heat emission by emitted thermal radiation may have an influence. Large areas have a higher emission than small areas. Analogously, the total heat emission of a recess is smaller than the total heat emission of an elevation although the surface of the recess may be equal to the surface of the elevation. This is due to the fact that a part of the emitted heat in the recess is collected by the recess itself.

In general, and not limited to the present embodiment, the evaporation side and/or back side may have two recesses with one recess being considerably larger than the other recess. It is typical that the larger recess is made for a coarse design of the temperature distribution of the crucible in operation whereas the small recess is made for a fine tuning of the temperature distribution. Therefore, in typical embodiments of the present invention, the smaller recess is embedded in the larger recess. This is also true for a multitude of recesses and/or one or more elevations and/or a combination of one or more elevations with one or more recesses. As an example, the cross-section depicted in Fig. 14C shows that the crucible comprises the larger recess 210. Larger in this context refers to the overall dimensions. Further, two smaller recesses 215 are embedded in this larger recess 210. Typically, the overall extension and/or the depth of the smaller recess is smaller than that of the larger recess.

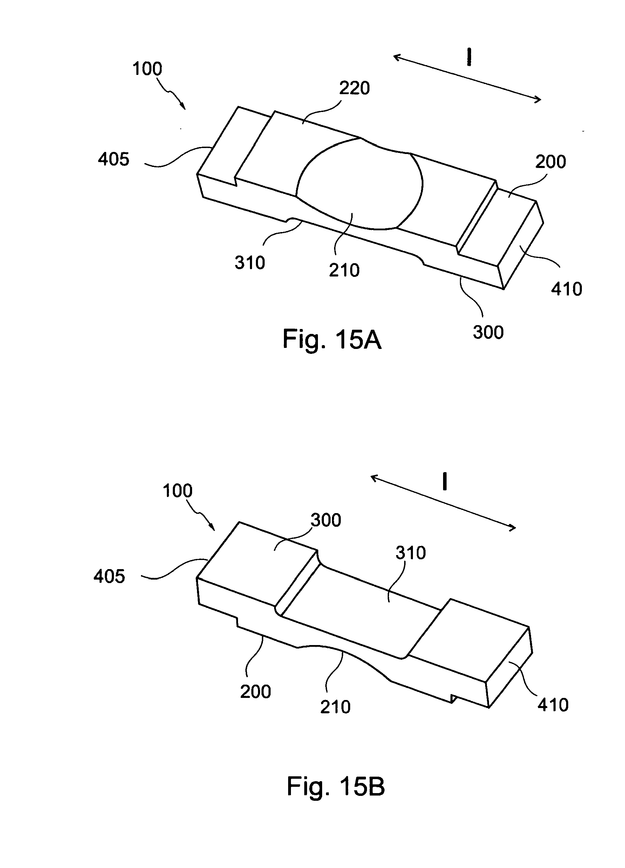

Figs. 15A and 15B show two schematic views of an embodiment of a crucible according to the present invention. In Fig. 15A the evaporation side 200 is shown having a step-shaped elevation 220 with a recess 210 being positioned in the middle of the elevation. The back side 300 is provided with a recess 310. At the face side and back side along the length of the crucible the contact areas 405 and 410 are shown.

The same crucible 100 of Fig. 15A is shown in Fig. 15B in a schematic view as seen from the back side 300. As can be seen, the recess 310 on the back side 300 is of rectangular shape whereas the recess 210 on the front side has a partly circular shape (which can be better seen in Fig. 15A). In general, the shape of a recess on the evaporation side and/or elevation side according to the present invention may have a circular, partly circular, ellipsoid, partly ellipsoid, cylindric, or partly cylindric circumference.

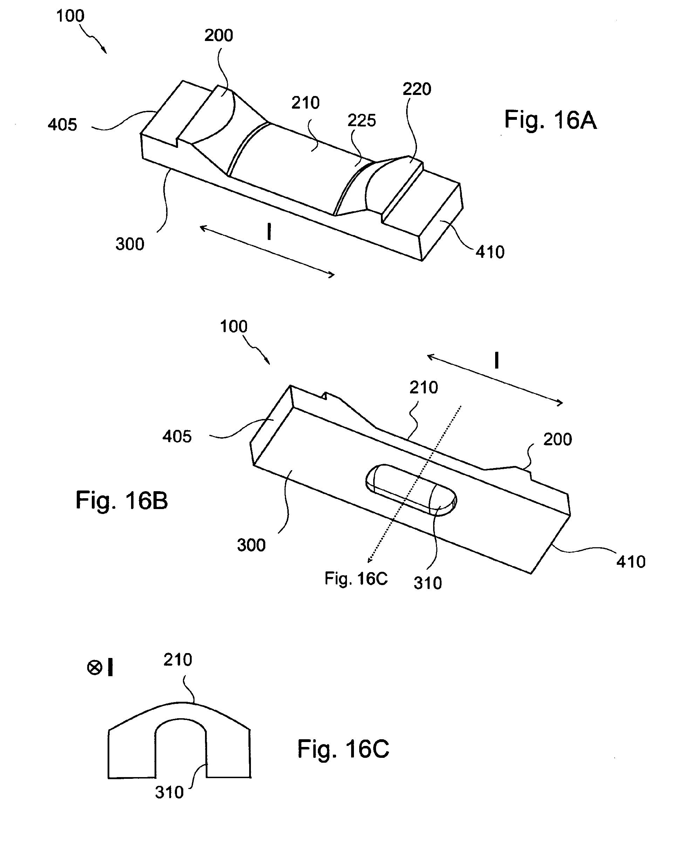

Figs. 16A and 16B show two schematic views of another embodiment of a crucible according to the present invention. As shown in Fig. 16A, the evaporation side 200 is provided with an elevation 220. The recess 210 is embedded in the elevation 220. Typically, "embedded" as used in the present application is to be understood as being "located within or on".

In the present embodiment, the edge region is the flat region on the evaporation side 200 close to the contact areas 405 and 410. The recess 210 has a bottom region that is not flat but slightly convex. In other words, the recess 210 is provided with an elevation of a convex shape. In general, as in this typical embodiment shown in Fig. 16A, it is possible that the evaporation side - and in some embodiments also the back side - is provided with an elevation that is positioned in a recess which is embedded in an elevation of the crucible.

Fig. 16B shows the same embodiment of the crucible depicted in Fig. 16A from a schematic back side view. As shown therein, the back side is provided with a recess 310. As typical for the present invention, the recess of the back side is positioned in the middle of the crucible along both the length and width direction of the crucible. The recess 310 is a two-stage recess having a region with straight walls close to the back surface and a region with bent walls shaping the bottom of the crucible.

Fig. 16C is a cross-sectional view of the crucible shown in Fig. 16B in a plane along the width of the crucible as indicated by the arrow in Fig. 16B. As can be seen in Fig. 16C, the crucible's thickness is the smallest in the middle of the crucible. The thickness is larger in the zones surrounding the middle. Hence, the region in the middle refers to the melting zone of the crucible having a reduced temperature when in operation. The regions around the melting zone are the evaporation zones having a higher temperature in operation of the crucible.

Generally, and not limited to any embodiment, the crucible of the present invention has a typical length of between 5 cm and 50 cm, more typically between 10 cm and 20 cm. The typical width of the crucible is between 0.5 cm and 5 cm, more typically between 1 cm and 3 cm. In many embodiments of the present invention, the crucible has a rectangular shape along a cross-section taken perpendicular to the thickness direction. Generally, the depth of a recess into the crucible is between 1 mm and 1 cm, more typically between 2 mm and 8 mm. Generally, the height of an elevation extending out from the crucible is between 1 mm and 1 cm, more typically between 2 mm and 8 mm. The depth of a recess is defmed as the maximum distance between recess bottom and the recess surrounding surface as seen only in the thickness direction of the crucible. Analogously, the height of an elevation is defined as the maximum distance between elevation peak and the elevation surrounding surface as seen only in the thickness direction of the crucible.

In general, according to the present invention, the evaporation side and the back side of a crucible are structured. The term "structured" in this context shall refer to a non-flat surface. The purpose of the structuring is many-fold. It is important to note that the special shape of the back surface and the evaporation surface interact when the crucible is in operation. The design of both surfaces shall be such that the evaporation efficiency and quality is as good as possible. The evaporation quality shall include the issue of thermal stress on the substrate during evaporation. Both the efficiency and quality depends, inter alia, on the shape of the evaporation distribution that is generated when material is fed to the crucible in operation. The shape of the evaporation distribution depends, inter alia, on the shape of the evaporation surface and the temperature distribution on that surface. In prior art it is known to have a crucible with a planar back side and a structured recess on the front side. However, the shape of the structured front side can not be freely designed in order to design the evaporation distribution since every structure on the evaporation side changes the temperature distribution within the crucible and on the crucible's evaporation side.

This is overcome by the present invention. By designing both the evaporation side and the back side the design and structuring of the evaporation side can be disentangled from temperature considerations. When designing the evaporation surface, the present invention allows focussing on the evaporation distribution characteristics resulting solely from the surface shape. In addition, in order to have the desired temperature distribution on the evaporation surface, the back side of the crucible is structured in order to arrive at this aim. In summation, the mutual design of the shape on the back side and the evaporation side of the crucible allows for the overall optimization of the evaporation distribution and thus the deposition efficiency and quality. This can be further enhanced by including a member in the crucible wherein the member is made of another material than the material of the crucible. This will be more thoroughly explained with respect to Fig. 23.

According to some embodiments the crucible according to the present invention has a symmetric shape along the length of the crucible. That is, the crucible can be mirrored along a mirror plane extending in the width direction intersecting the middle of the crucible. According to other embodiments of the present invention, the crucible has an asymmetric shape along the length of the crucible.

According to some embodiments the crucible according to the present invention has a symmetric shape along the width of the crucible. That is, the crucible can be mirrored along a mirror line extending in the length direction intersecting the middle of the crucible. According to other embodiments of the present invention, the crucible has an asymmetric shape along the width of the crucible.

In other embodiments, the crucible is symmetric along the thickness of the crucible. In other words, the non-flat structures on the evaporation side and on the back side are identical.

Typically, the crucible according to the present invention has no distinguished direction along the length and/or width of the crucible. In typical embodiments, the crucible according to the present invention is not suitable for storing a significant amount of liquid. The liquid is that part of the material fed to the crucible that is not evaporated. Generally, according to embodiments of the present invention, the width of the crucible is constant along the length direction and/or the length of the crucible is constant along the width direction of the crucible.

Figures 17A to 17C show further cross sectional views of an embodiment of the crucible according to the present invention with Fig. 17A being a cross-sectional view along the length of the crucible and Figures 17B and 17C being two cross-section views along the width at different positions.

In general, the crucible is heated by the current conducted through the crucible. In order to do so, a voltage is applied to the crucible. Typically, the voltage is applied so that the potential difference in the crucible extends along the length of the crucible. Typically, there is no potential difference along the width and the thickness of the crucible.

Hence, a current flows through the crucible from one side to the other side. In the view of Fig. 17A, the current I flows typically from the left side of the crucible to the right side or vice versa. This is indicated by the arrow in Fig. 17A. The crucible of the embodiment shown in Fig. 17A has a cross-section along the length of the crucible that varies in the thickness. This is shown in Figures 17B and 17C representing the cross-sectional view of the crucible at the positions indicated by the arrows in Fig. 17A. Closer to the middle of the crucible, the thickness is smaller. Hence, the cross-sectional view of the crucible closer to the middle, that is depicted in Fig. 17C, shows a rectangular crucible with a smaller thickness in comparison to the crucible cross section shown in Fig. 17B. In summation, the crucible shown in Figures17A-C has no variation of the thickness in the width direction of the crucible but only in the length direction. In more technical terms, the gradient of the crucible surface is 0 everywhere in the width direction of the crucible.

Fig. 17D shows a schematic equivalent circuit diagram showing the resistances the current I has to overcome when flowing from one side of the crucible to the other one. At the edge region of the crucible, there is a large cross-section of the crucible (see Fig. 17B). Hence, the resistance Rs in this region is small. Closer to the middle of the crucible, the cross-section along the width becomes smaller. Thus, the resistance increases. This is schematically depicted as the resistance Rm in Fig. 17D. At the position with the smallest cross-section of the crucible the resistance is the largest. At this position, the current per area, i.e. the current density is maximal resulting in a high temperature.

The heating power of the crucible can be calculated as the current square times resistance (P=I²*R). Hence, as the overall current through the crucible is identical at all cross sections along the length of the crucible, the heating increases linearly with the resistance. Consequently, the region in the middle of the crucible shown in Fig. 17A, that has the smallest cross-sectional area along the width of the crucible, is the hottest region with a decreasing temperature towards the front side and the back side of the crucible with respect to the length direction. As will be clear by looking at the cross-sectional views with respect to the width direction of the crucible shown in Figures 17B and 17C, the temperature along the width direction of the crucible is constant.

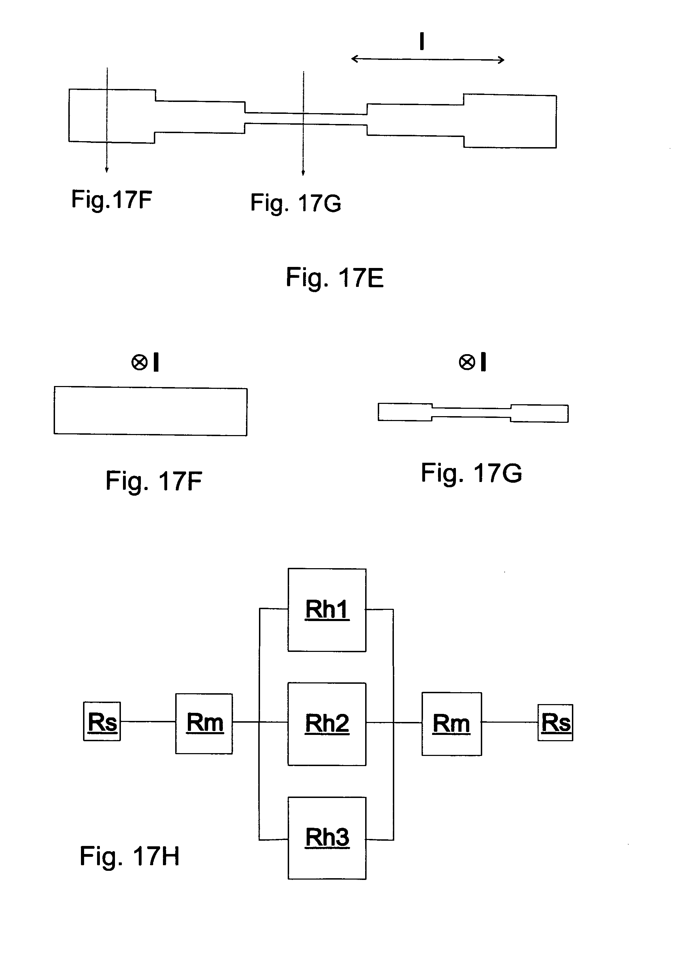

This situation explained with respect to Figures 17A-17D becomes different if the crucible is shaped in the width direction. This shall be explained with respect to the Figures 17E-17H.

Fig. 17E shows the cross-section of the embodiment of the crucible along the length of the crucible. As in the embodiment of Figure 17A, the crucible comprises three different thicknesses in this cross-sectional view.

The crucible's cross-section along the width is not shaped in the edge region, i.e. close to the front and back side. This is shown in Figure 17F. However, in the middle region with respect to the crucible's length, the crucible is shaped along the width. This is shown in Fig. 17G. Here, the crucible is provided with a recess on both the evaporation side and the back side.

Fig. 17H shows a schematic equivalent circuit diagram showing the resistances the current I has to overcome when flowing from one side of the crucible of Figures 17E-G to the other one. At the edge region of the crucible, there is a large cross-section of the crucible (see Fig. 17F). Hence, the resistance Rs in this region is small. Further, there is no shaping along the crucible's width. The current through the crucible is homogenously distributed over the complete width of the crucible.

The crucible may still have a rectangular cross-sectional shape along the width a bit closer to the middle. As explained previously with respect to Fig. 17D, the overall resistance increases resulting in a resistance Rm with Rm > Rs.

Closer to the middle and in particular in the middle along the length of the crucible, the cross-section along the width becomes smaller and, in addition, the crucible is shaped along the width as depicted in Fig. 17G. Thus, the overall resistance increases. In addition, the resistance Rh2 of the middle region along the width is larger in comparison to the resistance of areas outlying the middle region as in the middle region there is the smallest cross-section for the current to flow through. In the schematic equivalent diagram this means that the current has to pass a circuit having resistances arranged in parallel. In the very middle of the crucible, the cross-section is the smallest. Hence, the resistance is the largest; the current has to overcome the resistance Rh2. Outlying the middle region, the resistances Rh1 and Rh3 are smaller than the resistance Rh2 in the middle as the thickness of the crucible is larger in these regions.

In summation, the situation of the crucible depicted in Figures 17E-G can be simplified and illustrated by the equivalent schematic circuit diagram of Fig. 17H. In the event that the crucible has a shaped cross-section along the width, the current passing this shaped cross-section sees a number of resistances arranged in parallel. The resistance is the largest at the position where the crucible has the smallest thickness, such as Rh2 in the very middle of the crucible shown in Fig. 17G. The resistance is smaller in regions having a larger thickness, such as Rh1 and Rh3 in the regions outlying the middle region of the crucible shown in Fig. 17G. In the event of a symmetric shape of the crucible with respect to its width, the resistance Rh1 equals Rh3. In the event of an asymmetric shape of the crucible with respect to its width, Rh1 is different from Rh3. Either way though, the total resistance stemming from the parallel resistances Rh1, Rh2 and Rh3 is larger than the resistance Rm.

As a consequence, the current through regions having a higher resistance (such as Rh2) is smaller than the current through region having a smaller resistance (such as Rh1 or Rh3). The current takes its way along the smallest resistance. In the embodiment shown in Figures 17E-G, the current through the very middle along the width direction of the crucible (at the middle position along the length) is smaller than through the outlying regions. Hence, the middle region is heated less than the outlying regions.

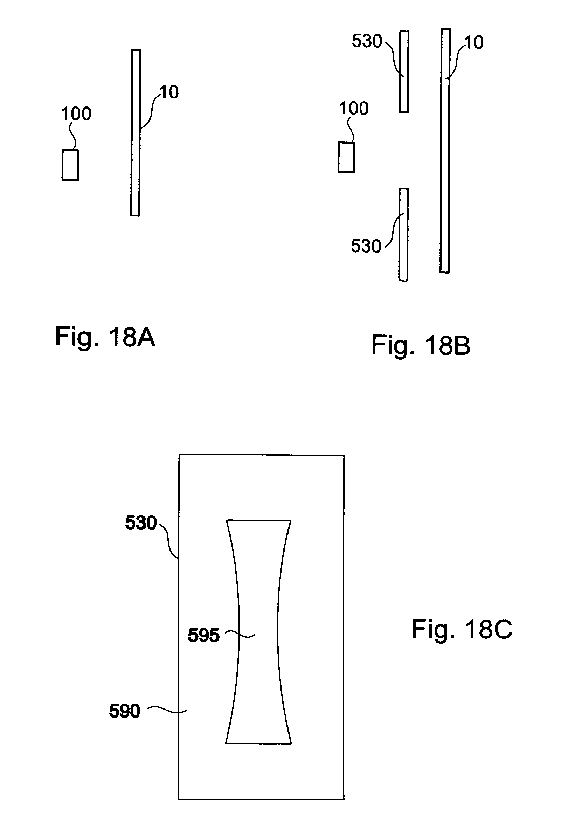

Figs. 18A, 18B, 19 and 20 show embodiments of the evaporation apparatus according to the present invention.

In Fig. 18A, the crucible 100 according to the present invention is positioned in front of a vertically arranged substrate 10.

In Fig. 18B, additional to the crucible 100 and the vertically oriented substrate 10, an aperture unit 530 is shown. The aperture unit 530 can be used in the evaporation apparatus according to the present invention in order to prevent evaporated material from the peripheral region of the evaporation distribution from impinging on the substrate 10. The aperture unit helps in further avoiding undesired irregularities in the coating thickness.

Typical aperture unit sizes are in the range of 500 and 1,200 mm. Typical aperture shapes are curved. The size and shape of the aperture depends, inter alia, on the substrate height. Fig. 18C shows a possible embodiment of an aperture unit 530 according to the present invention. The aperture unit comprises an open region 595 where the evaporated material can pass the aperture unit towards the substrate to be coated. The open region is arranged in the middle of the crucible. Typically, the open region has a curved shape. Further, the aperture unit comprises the closed region 595. Evaporated material is stopped from propagating towards the substrate to be coated by the closed region.

The aperture unit as shown in Fig. 18C is typically used in evaporation apparatuses having only one evaporation unit. In this event, the coating distribution has its maximum in the center. Hence, in order to guarantee a uniform coating, the open region of the aperture unit is shaped in a curved way with the smallest opening in the middle.

According to typical embodiments of the vertical evaporation apparatus according to the present invention, the substrate 10 travels horizontally past the evaporator crucible 100. Thereby, the evaporation apparatus according to the present invention provides a continuous coating process of the vertically arranged substrate in the horizontal direction. This continuous coating shall be called "in-line coating" within the present application.

According to further embodiments, the evaporation apparatus according to the present invention can be applied for web coating. Typically, the web is horizontally aligned and guided above one or more crucibles. In the event of several crucibles, these are typically identical. In the embodiments having several crucibles, these are typically aligned in a row, i.e. adjacent to each other in a straight line. Alternatively, the crucibles may be positioned displaced to each other. The displacement in this context typically refers to the position with respect to the width of the web to be coated.

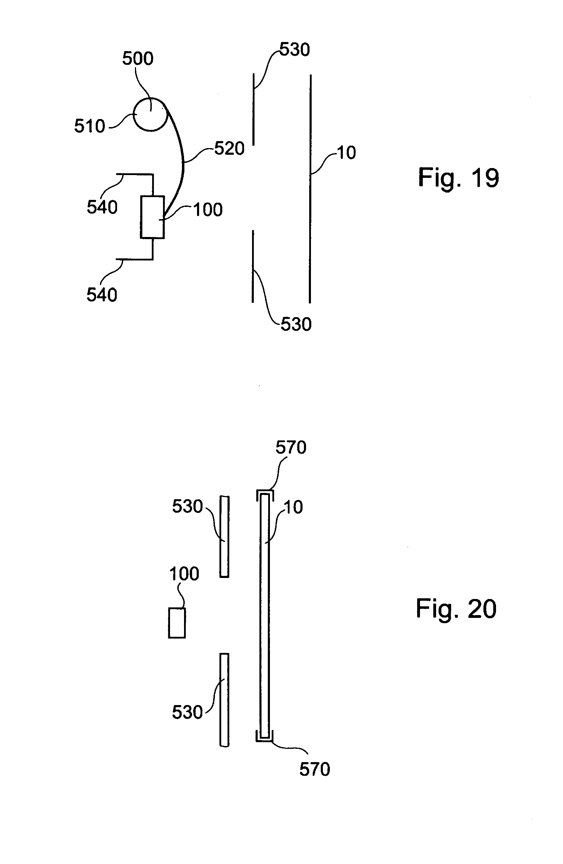

Fig. 19 shows another embodiment of the evaporation apparatus according to the present invention with a crucible 100, an aperture unit 530 and the vertically arranged substrate 10. The crucible 100 is connected to a voltage at its electrodes by connections 540. A voltage is applied in order to conduct current through the crucible 100 in order to heat it. The material 520 to be evaporated is fed to the crucible 100 from the material wire coil 510. Generally, the evaporation apparatus according to the present invention may comprise a coil carrier for carrying a coil with a material wire. As shown in Fig. 19, the coil carrier 500 carries the material wire coil 510 in order to feed the material wire 520 to the crucible 100. A coil carrier may be applicable in all embodiments of the evaporation apparatus according to the present invention.

In a typical embodiment of the evaporation apparatus according to the present invention, the crucible may be inclined. That is, the evaporation side of the crucible may be directed to some extent towards the substrate. In some embodiments, the inclination angle between crucible and horizontal is between 10° and 90°.

In general, the crucible 100 enables thin film forming of a material on a substrate. According to typical embodiments described herein, the material to be vapor deposited on the substrate can be a metal like aluminum, gold, copper, or alloys including at least one of these metals.

Generally, according to embodiments described herein, the material of the crucible is conductive. Typically, the material used is temperature resistant to the temperatures used for melting and evaporating. In general, the material of the crucible is resistant with regard to the material that is evaporated and/or the material that is generated in the evaporation process. For instance, aluminum is highly reactive and can cause significant damages to the crucible if an inadequate material of the crucible is chosen.

Typically, the crucible of the present invention is made of an electrically conductive ceramics such as a ceramics composite. Those ceramics are produced as a multi-component material. They are manufactured by adding a conductive component to a carrier matrix made of an insulator such as aluminum oxide or silicon nitride.

The typical resistance of the material that the crucible according to the present invention is made of is between 0.2 and 200 mΩ*cm.

According to typical embodiments, the crucible is made of one ore more materials selected from the group consisting of metallic boride, metallic nitride, metallic carbide, non-metallic boride, non-metallic nitride, non-metallic carbide, nitrides, titanium nitride, borides, graphite, TiB2, B₄C, and SiC. Typical lengths of the crucible are in the range of 100 mm and 500 mm whereas typical widths of the crucible are in the range of 30 mm and 100mm.

The material to be deposited is melted and evaporated by heating the evaporation crucible 100. Heating can be conducted by providing a power source (not shown) connected to the first electrical connection and the second electrical connection. For instance, these electrical connections may be electrodes made of copper or an alloy thereof. Thereby, heating is conducted by the current flowing through the body of the crucible 100. In Fig. 12, reference signs 405 and 410 refer to the contact areas of the crucible. Typical currents the crucible has to conduct are between 250 A and 1,000 A. The typical current depends on the material of the crucible and its overall cross-sectional surface. Typical voltages that the crucible is connected with are between 4 V and 30 V.

The temperature on the crucible surface in operation is typically chosen to be in the range of 1,000°C to 1,800°C, more typically between 1,300°C and 1,600°C, e.g., about 1,560°C. This is done by adjusting the current through the crucible accordingly. Typically, the crucible material is chosen such that its stability is not negatively affected by temperatures in that range. High temperature within the present application refers to the temperature typically needed for evaporation, e.g. between 1550° and 1600°, whereas lower temperature refers to the temperatures smaller than evaporation temperature. Typically, the region with a high temperature is between 1% and 20% of the overall surface of the evaporation side of the crucible, more typically between 1% and 10% of the surface. A small region having the high evaporation temperature results in a better design of the evaporation distribution. The temperature depends typically on the evaporation material to be evaporated.

In a typical method for evaporating, the material to be deposited, for example aluminum, is provided by continuously feeding the material with a feeding wire. In typical embodiments, the diameter of the feeding wire is chosen between 0.5 mm and 2.0 mm, more typically between 1.0 mm and 1.5 mm. The amount of material evaporated is provided by the diameter and the feeding speed of the feeding wire. According to a further embodiment, the wire can include a single element. In the case an alloy is to be deposited on the substrate, the wire can be provided with the material being an alloy. According to an even further embodiment, if an alloy is to be deposited on the substrate, several wires of the materials constituting the desired alloy can be provided to form the desired alloy. Thereby, the feeding speed of the wires in conjunction with the wire diameter can be adjusted to provide the desired alloy composition.

For instance, in the embodiment shown in Fig. 19 the material to be evaporated is fed to the crucible from the coil 510. The coil carrier typically comprises means for uncoiling the wire at a constant speed that can be set, for instance, by the operator of the evaporation apparatus. Typical feeding rates of the wire are in the range of between 5 and 250 cm/min, more typically between 10 and 125 cm/min. The wire 520 of the material to be deposited is uncoiled from the wire coil 510 and fed to the crucible 100 where it is evaporated.

In Fig. 20, means 570 adapted for supporting the substrate 10 in a vertical orientation are shown. These means may be, for instance, means for transporting the substrate past the crucible, e.g. a conveyor belt, driven rollers or the like. The means for supporting the substrate may contact the substrate at several positions, e.g. at the bottom side and at the top side of the substrate. These means for supporting the substrate are applicable in all embodiments of the evaporation apparatus according to the present invention. During the evaporation process, the substrates are driven past the crucible while they are coated with the material. Typically, the speed of the substrates is in the range of between 10 cm/min and 500 cm/min, more typically between 50 cm/min and 200 cm/min. In these cases, the means for transporting should be capable of transporting the substrate at those speeds.

As shown in Figs. 18A-20, the evaporation crucible 100 is positioned in front of a vertically arranged substrate 10. Depending on the distance of the evaporator crucible from the substrate, the size of the evaporation area on the substrate can be controlled.

In typical embodiments of the present invention, the crucible is positioned vertically. That is, the evaporation surface of the crucible is vertically arranged. The term "crucible" as used in the present application shall be understood as a unit capable of vaporizing material that is fed to the crucible when the crucible is heated. In other words, a crucible is defined as a unit adapted for transforming solid material into vapour. In typical embodiments of the present invention, the feeding rate at which the material is fed to the crucible and the temperature of the crucible are adjusted such that a substantial part of the solid material is directly transformed into material vapour. That is, the amount of liquid material on the crucible is very small in typical embodiments of the present invention. More particularly, it is typical that the liquid slowly disperses on the surface of the crucible in a distance in the range of 10 mm and 200 mm as seen from the point of feeding the wire to the crucible. However, the amount of liquid material is so small that the liquid can not freely flow and, in particular, does not flow due to gravitational forces. Typical amounts of liquid may be between 0.3 ml and 3,0 ml. In typical embodiments, the crucible is capable of storing liquid in a maximal range of this amount. Therefore, in typical embodiments of the present invention, the crucible may be inclined at high inclination angles α in relation to the horizontal even if the crucible used is planar without providing any recess for a liquid.

In typical embodiments of the present invention, when seen only in the vertical dimension, the crucible is positioned in the lower part of the substrate. That is, the crucible is typically positioned lower than the substrate's vertical centre. For instance, the crucible is positioned between 50 and 150 mm below the substrate's vertical centre. In other embodiments, the crucible is positioned between 0 and 150 mm, typically between 50 and 150 mm above the substrate's bottom. The examples given in this paragraph relate typically to asymmetric crucibles. Asymmetric in this context refers particularly to the length and/or width orientation of the crucible. In typical embodiments of a symmetric crucible, the crucible is positioned in the middle of the substrate, for instance 250 mm above the substrate's bottom.

The crucible according to the present invention may be asymmetric in the length direction and/or in the width direction of the crucible. Fig. 22 shows the equivalent schematic diagram for the case of an asymmetric crucible in the length direction wherein the crucible has no variation in the width direction. As can be seen, the crucible's thickness is large in the edge regions with respect to the length (resulting in a small resistance), and diminished towards the center of the crucible (resulting in a larger resistance). However, the smallest thickness is not centrally located with respect to the length but positioned to the right of the middle region when seen in the perspective of Fig. 22.

In typical embodiments, the evaporation distribution is not symmetrical due to the inclination and/or the shape of the crucible.

As an exemplary embodiment, a method of forming a thin film can be carried out by using an apparatus which is entirely placed in a vacuum chamber with a typical atmosphere of 10⁻² to 10⁻⁸ mbar, in particular 10⁻² to 10⁻⁶ mbar. Thereby, the thin film can be vapor deposited on a substrate without contamination of particles from the ambient atmosphere. In order to provide for a vacuum, the evaporation apparatus of the present invention is typically positioned in a vacuum chamber (not shown). The vacuum chamber is typically equipped with vacuum pumps (not shown) and/or tube outlets (not shown) for pumping the air out of the chamber.

As a further example, the embodiments described herein can be utilized for the coating of substrates for display technology or the like. Thereby, substrate size may be as follows. A typical glass substrate and, thereby, also a coating area can have dimensions of about 0.7 mm x 500 mm x 750 mm. Yet, the substrates that can be processed with the present invention can also have a size of about 1500 mm x 1850 mm.

As described above, for typical embodiments of the evaporation apparatus, the vertically arranged substrate is horizontally moved along the evaporation crucible. Thereby, the amount of material is integrated across the horizontal vapor distribution of the evaporation crucible.

Typically, the distance between aperture unit and substrate is between 50 and 200 mm. The typical distance between crucible and substrate is between 200 and 600 mm, for instance between 350 and 450 mm. The typical distance between aperture unit and crucible is between 150 and 400 mm.

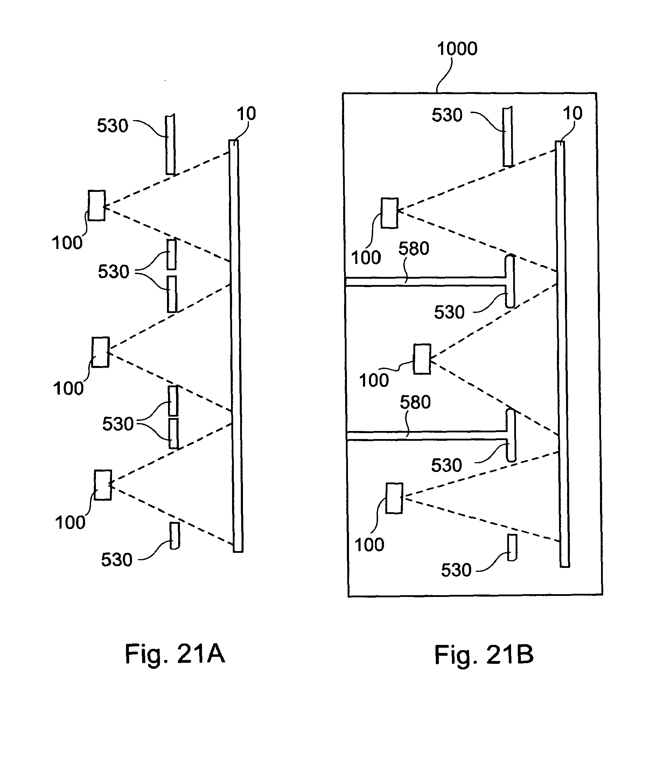

Fig. 21A and 21B show two further embodiments of an evaporation apparatus according to the present invention. Therein, three evaporation crucibles 100 are provided in front of a substrate 10. A respective aperture unit 530 is provided between each of the crucibles and the substrate. The crucibles are arranged horizontally next to each other. Consequently, the evaporation distributions of the evaporation crucibles are provided next to each other, such that the substantially homogeneous coating of the substrate can be provided. According to one embodiment, each evaporation crucible is loaded with a separate material wire. Typically, the wire for all crucibles is made of the same material. In the embodiments shown in Fig. 21A and 21B, coil carriers (not shown) can be provided for mounting the coils with the wires of material to be evaporated. Typically, the shape of the crucibles used is identical.

In the embodiment shown in Fig. 21B, the vacuum chamber 1000 is depicted in which the evaporation apparatus according to the present invention is located. It shall be understood that all embodiments of an evaporation apparatus according to the embodiment discussed herein can be positioned within a vacuum chamber.

According to the embodiment shown in Fig. 21B, crucibles 100 are positioned displaced to each other. That is, some of the crucibles are positioned closer to the substrate than other crucibles. In addition or alternatively, it is also possible (not shown) that the respective aperture units of each crucible are arranged displaced to each other. In general, the displacement of the crucibles and/or the aperture units may be alternating or following other logics. The displacement may improve the coating characteristics on the substrate.

In the embodiments with several crucibles, it is possible that one common aperture unit 530 as shown in Fig. 21B is used that has several apertures, e.g. each for one crucible. Further, the crucibles may be separated from each other by additional protection walls 580.

According to another aspect of the present invention, the crucible comprises a member 600. Typically, the crucible is made of a conductive material. The member is typically made of a material whose conductivity is smaller than the conductivity of the crucible's material. More typically, the member is electrically insulating. In the embodiment shown in Fig. 23, the member is positioned centrally with respect to the width and/or length of the crucible on the evaporation side. According to typical embodiments, the member is in a positive contact with the crucible.

As the member is typically non conductive, the current through the crucible does not flow through the member. As a result, several effects could be observed.

Firstly, the thickness of the conductive material of the crucible is reduced by the size of the member. As a consequence, the resistance in the region of the width of the member increases. The width direction of the member shall be defmed as being parallel to the width direction of the crucible. Secondly, the member itself does not heat up due to the applied voltage. Instead, the member is heated by heat conduction, i.e. by the contact with the heated crucible. Hence, typically, the member is colder than the surrounding material of the crucible when the crucible is in operation. This way, the member may be used as a melting zone being surrounded by evaporation zones, the so-called "hot spots". The evaporation zones have a temperature that is typically higher than the temperature of the melting zone.

By designing the crucible taking into account the electrical and/or thermal conductivity of the member, the temperature of the melting zone in relation to the temperature of the evaporation zones can be specified. In addition, the crucible may be shaped in order to further design the temperature distribution.

In particular, the member is typically the melting zone of the crucible. The temperature of the member can be adjusted by the amount of surface of the member that is in contact with the material of the crucible. A high amount allows high heat conduction.

In some embodiments of the present invention, a volume below the member is left blank. This is shown in Fig. 24 showing the cavity 610 arranged below the member 600. The cavity is embedded in the crucible and enclosed by the member and the crucible. The cavity is typically filled with a gas, such as air or nitrogen, or a liquid. In other embodiments, the cavity extends through the complete thickness of the crucible. The thermal conductivity along the cavity is typically small, i.e. in the range of 0.1 W/Km and 1 W/Km, more typically between 0.1 W/Km and 0.5 W/Km, even more typically between 0.1 W/Km and 0.2 W/Km. A cavity is typically provided below the member in the event that the member's temperature shall be reduced in comparison to the surrounding crucible.

While the foregoing is directed to embodiments of the invention, other and further embodiments of the invention may be devised without departing from the basic scope thereof, and the scope thereof is determined by the claims that follow.

## Claims

1. Crucible (100) for an evaporation apparatus, the crucible having a length, a width, and a thickness,
the crucible having an evaporation side (200) for receiving and evaporating material (520) to be evaporated and a back side (300) located on the back of the evaporation side,
wherein each of the evaporation side and the back side has a non-flat surface.

2. Crucible according to claim 1, wherein the evaporation side has a recess (210,215) and/or an elevation (220,225).

3. Crucible according to claim 2, wherein the recess (210,215) in the evaporation side has a concave shape.

4. Crucible according to claim 2 or 3, wherein the elevation (220, 225) on the evaporation side has a convex shape.

5. Crucible according to claim 2 to 4, wherein the recess and/or elevation extends along the width of the crucible.

6. Crucible according to claim 2 to 5, wherein the recess and/or elevation extends along the length of the crucible.

7. Crucible according to any of claims 2 to 6, wherein the recess and/or elevation extends at least 50% of the total evaporation side.

8. Crucible according to any of the preceding claims, wherein the back side has a recess (310,315) and/or an elevation.

9. Crucible according to claim 8, wherein the recess (310,315) in the back side has a concave shape.

10. Crucible according to claim 8 to 9, wherein the recess and/or the elevation extends on the back side along the width of the crucible.

11. Crucible according to any of claims 8 to 10, wherein the recess and/or the elevation on the back side extends along the length of the crucible.

12. Crucible according to any of claims 8 to 11, wherein the recess and/or the elevation extends at least 50% of the total back side.

13. Crucible according to any of the preceding claims, wherein the thickness between the evaporation side surface and the back side surface is smallest in middle of the crucible along its width and/or its length.

14. Crucible according to any of the preceding claims, wherein the crucible is able to be heated to a temperature of up to 1,700°C.

15. Crucible according to any of the preceding claims, wherein the crucible is made of an electrically conductive ceramics.

16. Crucible according to any of the preceding claims, wherein the crucible (100) further comprises contact areas (405,410) for being connected to a power source.

17. Crucible according to any of the preceding claims, wherein the crucible has a length of between 5 cm and 50 cm and/or a width of between 1 cm and 10 cm.

18. Crucible according to any of the preceding claims wherein the thickness of the crucible is smallest in the middle in respect to the width of the crucible and increases continuously towards the edge of the crucible.

19. Crucible according to claim 18 wherein the thickness increases in a region of +/-10% from the middle in relation to the overall width of the crucible.

20. Crucible according to any of the preceding claims wherein the crucible has a recess of between 2 mm and 8 mm depth.

21. Crucible according to any of the preceding claims wherein the crucible has an elevation of between 2 mm and 8 mm height.

22. Crucible according to any of the preceding claims wherein the evaporation side has an elevation (220) with a recess (210) embedded in the elevation.

23. Crucible according to claim 22, wherein the depth of the recess is larger than the height of the elevation.

24. Crucible according to any of the preceding claims, wherein two recesses (310, 315) are arranged on the back side.

25. Crucible according to any of the preceding claims, wherein the evaporation side has a recess (210,215) and the back side has a recess (310,315)
wherein both recesses are arranged such that the thickness of the crucible becomes smallest in the middle of the crucible.

26. Crucible according to any of the claims 1 to 25 wherein the evaporation side and the back side have such a structured surface that the crucible provides two positions that have the smallest thickness of the crucible.

27. Crucible according to any of the preceding claims having a symmetric shape.

28. Crucible according to any of claims 1 to 26 having an asymmetric shape.

29. Crucible according to any of the preceding claims wherein the crucible has a varying thickness.

30. Crucible according to any of the preceding claims, wherein the crucible is made of a first material and the crucible further comprises a member (600) made of a second material.

31. Crucible according to claim 30, wherein the second material is an insulator.

32. Evaporation apparatus having at least one crucible according to any of the preceding claims.

33. Evaporation apparatus according to claim 32, further comprising a coil carrier (320) for feeding a wire (300) of the material to be deposited to the crucible (100).

34. Evaporation apparatus according to any of the claims 32 to 33, further comprising means (570) for continuously transporting the substrate (10) in a vertical orientation.

35. Evaporation apparatus according to any of the claims 32 to 34, further comprising an aperture unit (530).

36. Evaporation apparatus according to any of the claims 32 to 35 with at least two crucibles according to any of claims 1 to 31.

37. Evaporation apparatus according to claim 36, wherein at least one of the at least two crucibles is arranged displaced to at least one of the at least two other crucibles.
